# EUROPÄISCHE PATENTSCHRIFT

(11) **EP 2 591 548 B1**
(45) Veröffentlichungstag und Bekanntmachung des Hinweises auf die Patenterteilung: **27.02.2019**
(21) Anmeldenummer: 11721294.4
(22) Anmeldetag: 18.05.2011
(51) Int. Cl.: H03F 1/32, H03F 1/48, H03F 3/45

(54) **LINEARER DIFFERENTIELLER VERSTÄRKER MIT HOHER EINGANGGSIMPEDANZ**
LINEAR DIFFERENTIAL AMPLIFIER HAVING HIGH INPUT IMPEDANCE
AMPLIFICATEUR DIFFÉRENTIEL LINÉAIRE À HAUTE IMPÉDANCE D'ENTRÉE

(30) Priorität: 09.07.2010 DE 102010026629
(43) Veröffentlichungstag der Anmeldung: 15.05.2013
(73) Patentinhaber: Rohde & Schwarz GmbH & Co. KG, 81671 München (DE)
(72) Erfinder: LANDOLT, Oliver, 82024 Taufkirchen (DE)
(74) Vertreter: Körfer, Thomas
(86) Internationale Anmeldenummer: PCT/EP2011/058063
(87) Internationale Veröffentlichungsnummer: WO 2012/004039

(56) Entgegenhaltungen:
- EP-A1- 1 033 809
- US-A- 4 769 617
- US-A- 5 587 689
- US-A1- 2009 184 766

## Beschreibung

Die Erfindung betrifft einen Verstärker, insbesondere einen differentiellen Verstärker.

Herkömmlich bestehen differentielle Verstärker aus zumindest zwei Transistoren, welche zu einem differentiellen Paar verschaltet sind. Solche einfache Verstärker zeichnen sich jedoch durch eine schlechte Linearität aus. Die Linearität für Verstärker kann durch Einfügen von Widerständen in den Emitterpfad verbessert werden. Hierdurch sinkt jedoch die Effizienz des Verstärkers. Darüber hinaus wird so gleichzeitig der Verstärkungsfaktor reduziert.

Das Dokument US 2009/0184766 A1 zeigt eine Verstärkerschaltung mit einem ersten differentiellen Paar und in Serie geschaltet einem zweiten differentiellen Paar. Das zweite differentielle Paar ist dabei an Steueranschlüssen überkreuz zumindest mittelbar mit einem differentiellen Ausgangssignal des ersten differentiellen Paars verbunden. Parallel geschaltet zu dem zweiten differentiellen Paar ist ein sogenannter "Current Mirror" bestehend aus einem dritten differentiellen Paar.

Weiterhin bekannt ist ein Verstärker basierend auf 4 Transistoren, Caprio's Quad. Ein solcher Verstärker zeichnet sich durch eine hohe Linearität und einen einstellbaren Verstärkungsfaktor aus. So zeigt "Precision differential voltage-current converter, Raimondo Caprio, Electronics letters, Vol. 9, No. 6, 1973" einen solchen differentiellen Verstärker. Insbesondere bei hohen Frequenzen weist ein Verstärker nach Caprio jedoch ein ungünstiges Verhalten auf.

Der Erfindung liegt die Aufgabe zu Grunde, einen differentiellen Verstärker zu schaffen, welcher bei einem einstellbaren Verstärkungsfaktor über einen breiten Frequenzbereich eine hohe Linearität gewährleistet.

Die Aufgabe wird erfindungsgemäß durch die Merkmale des unabhängigen Anspruchs 1 gelöst. Vorteilhafte Weiterbildungen sind Gegenstand der hierauf rückbezogenen Unteransprüche.

Ein differentieller Verstärker verfügt erfindungsgemäß über eine Verstärkerschaltung bestehend aus zwei differentiellen Paaren. Ein erstes differentielles Paar ist in Serie zu einem zweiten differentiellen Paar geschaltet. Das zweite differentielle Paar ist an Steueranschlüssen überkreuz zumindest mittelbar mit einem differentiellen Ausgangssignal des ersten differentiellen Paars verbunden. Das erste differentielle Paar und das zweite differentielle Paar bilden einen ersten differentiellen Strompfad und einen zweiten differentiellen Strompfad. Dem ersten Strompfad ist eine erste Nachbildungseinrichtung parallel geschaltet. Dem zweiten Strompfad ist eine zweite Nachbildungseinrichtung parallel geschaltet.

Ein erfindungsgemäßer differentieller Verstärker beinhaltet bevorzugt einen Verstärker entsprechend Caprio's Quad. Dieser besteht bevorzugt aus vier Transistoren und zwei Widerständen. Ein erstes differentielles Paar von Transistoren ist dabei mit ihren Kollektoranschlüssen mit den differentiellen Signalausgängen verbunden. Mit ihren Basisanschlüssen sind sie mit differentiellen Signaleingängen verbunden. Die Emitteranschlüsse dieses ersten differentiellen Paars sind mit Kollektoranschlüssen eines zweiten differentiellen Paars von Transistoren verbunden. Die Emitteranschlüsse dieses zweiten Paars sind über die Widerstände und eine Stromquelle mit Masse verbunden. Die Basisanschlüsse dieses zweiten Paars ist überkreuz mit den Kollektoranschlüssen verbunden.

Parallel zu dem ersten differentiellen Paar ist bevorzugt ein zweites differentielles Paar bestehend aus einem fünften und einem sechsten Transistor geschaltet. Dabei ist die Basis des fünften Transistors mit der Basis eines zweiten Transistors des ersten Paars und die Basis des sechsten Transistors mit der Basis eines ersten Transistors des ersten Paars verbunden. Die Kollektoren des ersten und fünften Transistors und des zweiten und sechsten Transistors sind dabei miteinander verbunden. Weiterhin ist bevorzugt ein viertes differentielles Paar von Transistoren in Serie zu dem dritten differentiellen Paar geschaltet. Die Kollektoren des vierten differentiellen Paars bestehend aus einem siebten und einem achten Transistor sind mit den Emittern des dritten differentiellen Paars verbunden. Die Basisanschlüsse und die Emitteranschlüsse des vierten differentiellen Paars sind mit den Basisanschlüssen bzw. den Emitteranschlüssen des zweiten differentiellen Paars verbunden. So wird eine hohe, einstellbare Verstärkung bei günstigen Hochfrequenzeigenschaften erreicht.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: einen ersten exemplarischen differentiellen Verstärker;
- Fig. 2: die Kennlinie des ersten exemplarischen Verstärkers;
- Fig. 3: einen zweiten exemplarischen differentiellen Verstärker;
- Fig. 4: die Kennlinie des zweiten exemplarischen Verstärkers;
- Fig. 5: einen dritten exemplarischen differentiellen Verstärker, und
- Fig. 6: ein Ausführungsbeispiel des erfindungsgemäßen differentiellen Verstärkers.

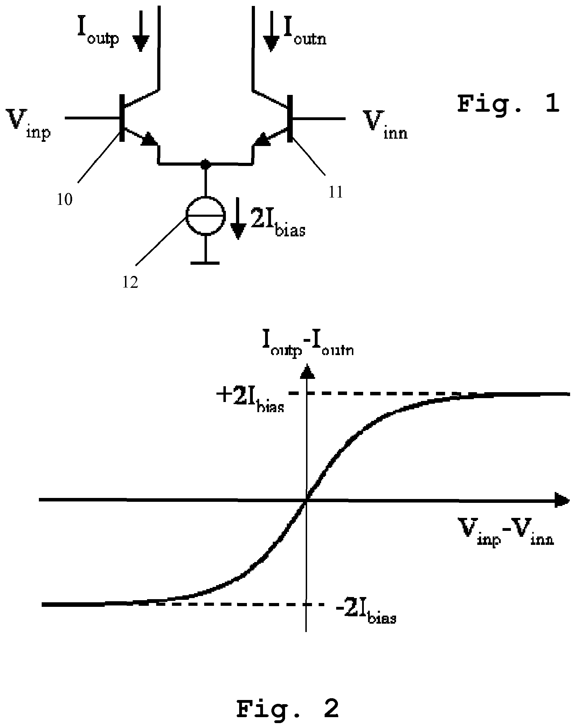

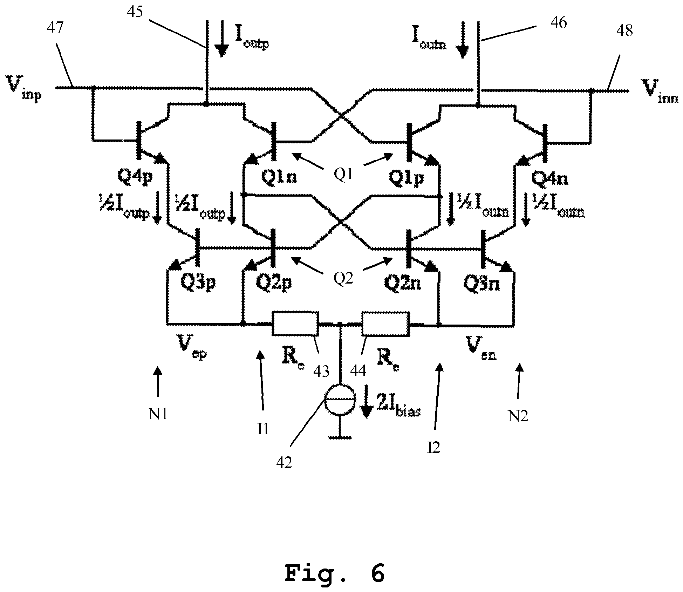

Zunächst wird anhand der Fig. 1 bis 5 der Aufbau und die Funktionsweise verschiedener exemplarischer differentieller Verstärker und die der gegenwärtigen Erfindung zu Grunde liegende Problematik erläutert. Abschließend wird mittels Fig. 6 der Aufbau und die Funktionsweise eines Ausführungsbeispiels des erfindungsgemäßen Verstärkers veranschaulichen. Identische Elemente wurden in ähnlichen Abbildungen zum Teil nicht wiederholt dargestellt und beschrieben.

Fig. 1 zeigt ein differentielles Paar bestehend aus zwei Transistoren 10, 11 als Kern der meisten elektronischen differentiellen Verstärker. Das differentielle Eingangssignal Vᵢₙ ist die Differenz der beiden differentiellen Eingangssignale Vᵢₙₚ, Vᵢₙₙ. Das differentielle Ausgangssignal Iₒᵤₜ ist die Differenz der differentiellen Ausgangssignale Iₒᵤₜₚ, Iₒᵤₜₙ. Der Ausgangsstrom kann dabei maximal eine Höhe von +/-2I_{bias}, den Strom einer Stromquelle 12, erreichen. Die Basis des ersten Transistors 10 ist dabei mit dem Eingangssignal Vᵢₙₚ beaufschlagt, während die Basis des zweiten Transistors 11 mit dem Eingangssignal Vᵢₙₙ beaufschlagt ist. Die Emitter der beiden Transistoren 10, 11 sind miteinander und mit der Stromquelle 12 verbunden. Der zweite Anschluss der Stromquelle 12 ist mit Masse verbunden. An den Kollektoren der Transistoren 10, 11 liegen die differentiellen Ausgangsströme Iₒᵤₜₚ und Iₒᵤₜₙ an.

Fig. 2 zeigt die Spannungs-Strom-Kennlinie des exemplarischen Verstärkers aus Fig. 1. Deutlich erkennbar ist die nichtlineare Form der Kennlinie über weite Spannungsbereiche. Für Applikationen, bei welchen eine hohe Linearität des Verstärkers notwendig ist, muss somit der Spannungsbereich, in welchem der Verstärker eingesetzt wird signifikant limitiert werden. Weiterhin nachteilhaft an diesem Verstärker ist, dass der Verstärkungsfaktor lediglich von den eingesetzten Transistoren abhängig ist und nicht eingestellt werden kann. Ein weiterer Nachteil des in Fig. 1 gezeigten differentiellen Verstärkers ist, dass sowohl der Verstärkungsfaktor wie auch der maximale Ausgangsstrom +/-2I_{bias} durch denselben Parameter, I_{bias}, eingestellt werden. Auf Grund dieser physikalischen Abhängigkeit ist es nicht möglich, den Verstärkungsfaktor und das maximale Ausgangssignal unabhängig einzustellen.

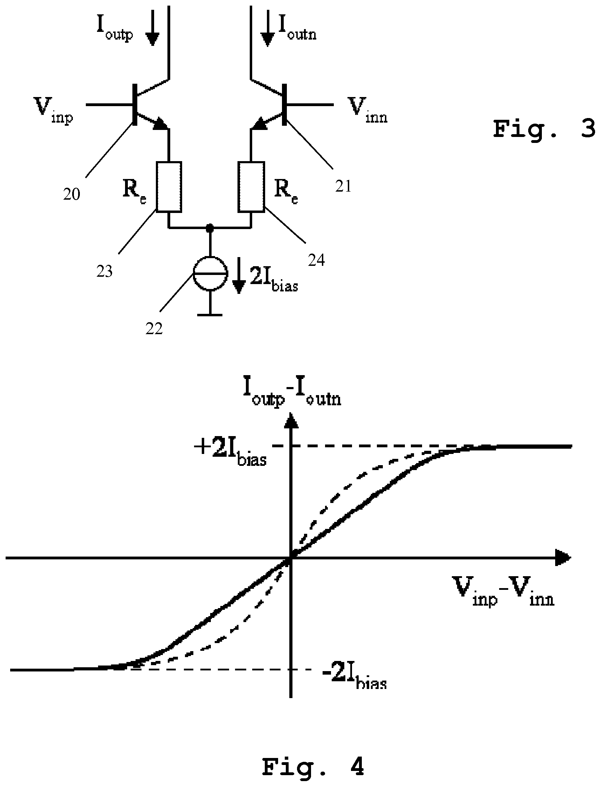

Die Linearität des in Fig. 1 gezeigten Verstärkers kann verbessert werden, indem ohmsche Wiederstände in den Emitterstrompfad eingefügt werden. Ein solcherart verbesserter Verstärker wird in Fig. 3 gezeigt. Die Emitter der Transistoren 20, 21 sind jeweils mit einem ohmschen Widerstand 23, 24 verbunden. Die ohmschen Widerstände 23, 24 wiederrum sind mit der Stromquelle 22, welche der Stromquelle 12 aus Fig. 1 entspricht, verbunden. Auch bei diesem Verstärker beträgt der maximale Ausgangsstrom +/-2I_{bias}.

Fig. 4 zeigt die Kennlinie des in Fig. 3 dargestellten exemplarischen differentiellen Verstärkers. Deutlich sichtbar ist die deutliche Verbesserung der Linearität gegenüber der gestrichelt gezeichneten Kennlinie aus Fig. 2. So kann über einen deutlich größeren Spannungsbereich eine hohe Linearität erreicht werden. Eine Einschränkung des Spannungsbereichs muss lediglich deutlich geringer ausfallen als bei dem Verstärker nach Fig. 1. Ein Nachteil des in Fig. 3 dargestellten differentiellen Verstärkers ist jedoch die Verringerung des Verstärkungsfaktors. So weist die in Fig. 4 gezeigte Kennlinie im linearen Bereich eine deutlich geringere Steigung auf als die gestrichelt dargestellte Kennlinie, welche der Kennlinie aus Fig. 2 entspricht.

Der in Fig. 3 dargestellte Verstärker dagegen ermöglicht auf Grund der ohmschen Widerstände 23, 24 eine unabhängige Einstellung der beiden Parameter. Da jedoch lediglich positive ohmsche Widerstände realisierbar sind, kann der Verstärkungsfaktor gegenüber dem Verstärkungsfaktor des differentiellen Verstärkers aus Fig. 1 durch die ohmschen Wiederstände 23, 24 lediglich verringert werden. D. h. eine Erhöhung der Steigung der Verstärkerkennlinie ist mit diesem Verstärkerkonzept nicht möglich.

In Applikationen, in welchen sehr kleine Eingangsspannungen verstärkt werden müssen, wäre es wünschenswert eine hochlineare Spannungs-Strom-Kennlinie zu erhalten, ohne den Verstärkungsfaktor zu verschlechtern. Idealerweise sollte die Spannungs-Strom-Kennlinie des Verstärkers bis zum maximalen Ausgangssignal vollständig linear bleiben.

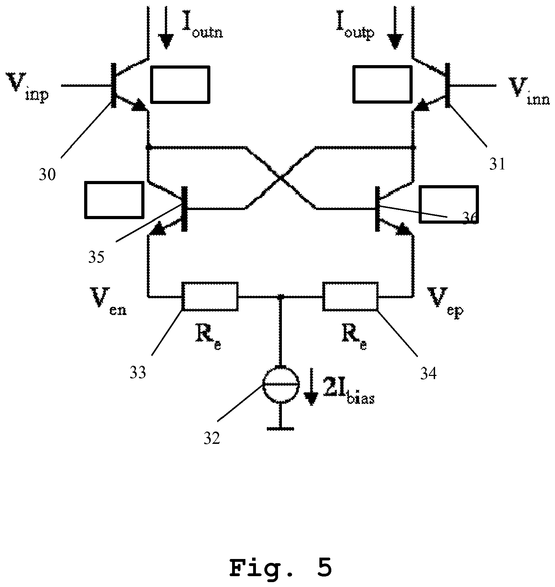

Ausgangspunkt der gegenwärtigen Erfindung ist der sogenannte "Caprio's Quad". In Fig. 5 wird ein solcher differentieller Verstärker dargestellt. Die Basis eines ersten und zweiten Transistors 30, 31 ist jeweils mit einer differentiellen Eingangsspannung verbunden. Die Emitter dieser Transistoren 30, 31 sind jeweils mit einem Kollektor eines weiteren Transistors 35, 36 verbunden. Weiterhin sind die Emitter der Transistoren 30, 31 überkreuz mit den Basisanschlüssen der Transistoren 36, 35 verbunden. Die Emitteranschlüsse der Transistoren 35, 36 sind jeweils mit einem Widerstand 33, 34 verbunden. Die Widerstände 33, 34 sind über eine Stromquelle 32 mit Masse verbunden. An den Kollektoren der Transistoren 30, 31 liegen die differentiellen Ausgangssignale Iₒᵤₜₙ, Iₒᵤₜₚ an.

Der Spannungsabfall Vᵢₙₚ - Vₑₚ ist dabei die Summe der Basis-Emitter-Spannungen der Transistoren 30, 36. Der Spannungsabfall Vᵢₙₙ - Vₑₙ entspricht den Basis-Emitter-Spannungen der Transitoren 31, 35. Die Kollektorströme der Transistoren 30, 35 entsprechen dem differentiellen Ausgangssignal Iₒᵤₜₙ. Die Kollektorströme der Transitoren 31, 36 entsprechen dem differentiellen Ausgangssignal Iₒᵤₜₚ. In einer sehr guten Näherung entspricht der Spannungsabfall Vᵢₙₚ - Vₑₚ und Vᵢₙₙ - Vₑₙ einander, da sie jeweils der Summe zweiter Basis-Emitter-Spannungen ausgehend von identischen Strömen entsprechen. Die Spannungsdifferenz Vₑₚ - Vₑₙ ist daher nahezu identisch zu der differentiellen Eingangsspannung Vᵢₙₚ - Vᵢₙ. Der differentielle Ausgangsstrom ist somit (Vₑₚ - Vₑₙ)/Rₑ. Dies entspricht zu einer sehr guten Näherung bis zum maximalen Ausgangssignal dem Strom (Vᵢₙₚ - Vᵢₙₙ)/Rₑ. Wenn der maximale Ausgangsstrom 2I_{bias} erreicht ist, fließt dieser gesamte Strom durch eine Seite der Schaltung.

Der Verstärker aus Fig. 5, Caprio's Quad, bietet die gewünschte hohe Linearität bis zum maximalen Ausgangssignal. Gleichzeitig können das maximale Ausgangssignal und der Verstärkungsfaktor völlig unabhängig voneinander eingestellt werden. Das maximale Ausgangssignal wird von dem Strom I_{bias}, welcher von der Stromquelle 32 zur Verfügung gestellt wird, eingestellt. Der Verstärkungsfaktor wird durch die Widerstände 33, 34 eingestellt. Diese sind dabei identisch. Durch Erhöhung der Widerstände derart, dass 1 durch Rₑ kleiner als der Verstärkungsfaktor des individuellen Transistors 30, 31 wird, kann sogar ein Verstärkungsfaktor erreicht werden, welcher größer ist als der eines herkömmlichen differentiellen Paars.

Nachteilhaft an der in Fig. 5 gezeigten Verstärkerschaltung ist jedoch ihr Verhalten bei höheren Frequenzen. Durch die Kreuzverbindungen zwischen den Transistoren 35 und 36 fließt ein Ausgangsstrom Iₒᵤₜₙ durch den Eingangstransistor 30, welcher mit der Eingangsspannung Vᵢₙₚ verbunden ist. Gleichzeitig fließt der Ausgangsstrom Iₒᵤₜₚ durch den Eingangstransistor 31, welcher mit der Eingangsspannung Vᵢₙₙ verbunden ist. Als Resultat der Kreuzverbindungen der Ströme ergibt sich eine negative Eingangsadmittanz der Schaltung bei Gleichstrom. Zusätzlich zu dieser statischen Komponente zeigt sich, dass im Wechselstromfall die Eingangsadmittanz einer negativen Kapazität entspricht. Im Gegensatz hierzu sind die Eingangsleitfähigkeit und Impedanz bei den in Fig. 1 und Fig. 3 gezeigten Verstärkerschaltungen jeweils stets positiv. Diese dynamischen Schwierigkeiten erlauben den Einsatz der in Fig. 5 gezeigten Verstärkerschaltung lediglich in verhältnismäßig langsamen Schaltungen. Durch eine Reduktion der Bandbreite können diese Probleme somit beseitigt werden.

Die dynamischen Schwierigkeiten der in Fig. 5 gezeigten Verstärkerschaltung wachsen zudem mit abfallendem Rₑ an. Die theoretische Möglichkeit eine hohe Verstärkung zu realisieren, indem Rₑ nahe Null angesetzt wird, kann somit in der Praxis nicht erreicht werden.

Der erfindungsgemäße differentielle Verstärker basiert grundlegend ebenfalls auf dem bekannten Verstärker nach Fig. 5 - Caprio's Quad. Eine negative Eingangsadmittanz wird jedoch durch Hinzufügen einer positiven Admittanz derselben Magnitude und Phase über einen großen Frequenzbereich kompensiert. Ein solcher erfindungsgemäßer differentieller Verstärker ist in Fig. 6 dargestellt.

Ein erster Transistor Q1n ist mit seiner Basis mit dem Eingangssignal Vᵢₙₙ verbunden. Der Kollektor des ersten Transistors Q1n ist mit einem Ausgang 45 verbunden. Die Basis eines zweiten Transistors Q1p ist mit dem differentiellen Eingangssignal Vᵢₙₚ verbunden. Der Kollektor des zweiten Transistors Q1p ist mit einem zweiten differentiellen Ausgang 46 verbunden. Der Emitter des ersten Transistors Q1n ist mit dem Kollektor eines dritten Transistors Q2p verbunden. Die Basis des dritten Transistors Q2p ist mittels einer Kreuzverbindung mit dem Emitter des zweiten Transistors Q1p verbunden. Der Emitter des zweiten Transistors Q1p ist weiterhin mit dem Kollektor eines vierten Transistors Q2n verbunden. Die Basis des vierten Transistors Q2n ist darüber hinaus ebenfalls mittels einer Kreuzverbindung mit dem Emitter des ersten Transistors Q1n verbunden. Der Emitter des dritten Transistors Q2p ist über einen Widerstand 43 mit einer Stromquelle 42 verbunden. Der Emitter des vierten Transistors Q2n ist ebenfalls über einen Widerstand 44 mit der Stromquelle 42 verbunden. Die Stromquelle 42 ist gegen Masse geschaltet.

Die Transistoren Q1n und Q1p bilden dabei ein erstes differentielles Paar Q1. Die Transistoren Q2n und Q2p bilden dabei ein zweites differentielles Paar Q2. Die Transistoren Q1n und Q2p bilden einen ersten Strompfad I1. Die Transistoren Q1p und Q2n bilden einen zweiten Strompfad I2.

Die bislang geschilderte Schaltung entspricht der Verstärkerschaltung aus Fig. 5. Der Kollektor eines fünften Transistors Q4p ist ebenfalls mit dem ersten Ausgangsanschluss 45 verbunden. Die Basis des fünften Transistors Q4p ist ebenfalls mit dem Eingang 47 verbunden. Der Emitter des fünften Transistors Q4p ist mit dem Kollektor eines siebten Transistors Q3p verbunden. Die Basis des siebten Transistors Q3p ist mit der Basis des dritten Transistors Q2p verbunden. D. h. die Basis des siebten Transistors Q3p ist über die Kreuzverbindung ebenfalls mit dem Emitter des zweiten Transistors Q1p verbunden. Der Emitter des siebten Transistors Q3p ist darüber hinaus über den Widerstand 43 mit der Stromquelle 42 verbunden. D. h. der Emitter des siebten Transistors ist mit dem Emitter des dritten Transistors verbunden.

Weiterhin ist der Kollektor eines sechsten Transistors Q4n mit dem Ausgang 46 und damit auch mit dem Kollektor des zweiten Transistors Q1p verbunden. Die Basis des sechsten Transistors Q4n ist mit dem Eingang 48 und damit mit der Basis des ersten Transistors Q1n verbunden. Der Emitter des sechsten Transistors Q4n ist darüber hinaus mit dem Kollektor eines achten Transistors Q3n verbunden. Die Basis des achten Transistors Q3n ist dabei mit der Basis des vierten Transistors Q2n und damit über die Kreuzverbindung mit dem Emitter des Transistors Q1n verbunden. Der Emitter des achten Transistors Q3n ist über den Widerstand 44 mit der Stromquelle 42 verbunden. D. h. der Emitter des achten Transistors Q3n ist mit dem Emitter des vierten Transistors Q2n verbunden. Die Transistoren Q4p und Q3p bilden dabei eine erste Nachbildungseinrichtung N1. Die Transistoren Q4n und Q3n bilden dabei eine zweite Nachbildungseinrichtung N2.

Dabei weisen bevorzugt sämtliche Transistoren übereinstimmende Kennlinien auf. Idealerweise sind sämtliche Transistoren identisch. Da die Basisanschlüsse und die Emitteranschlüsse der Transistoren Q2p und Q3p miteinander verbunden sind, weisen diese identische Kollektorströme ½ Iₒᵤₜₚ auf. Ebenso sind die Kollektorströme der Transistoren Q2n und Q3n identisch ½ Iₒᵤₜₙ. Der Spannungsabfall Vᵢₙₚ - Vₑₚ ist die Summe der Basis-Emitter-Spannungen der Transistoren Q1p und Q2p oder Q3p deren Kollektorströme jeweils ½ Iₒᵤₜₙ und ½ Iₒᵤₜₚ sind. Der Spannungsabfall Vᵢₙₙ - Vₑₙ ist identisch zu dem Spannungsabfall von Vᵢₙₚ - Vₑₚ, da er ebenfalls aus zwei Basis-Emitter-Spannungen mit den selben Strömen in umgekehrter Richtung entspricht. Der differentielle Ausgangsstrom Iₒᵤₜₚ - Iₒᵤₜₙ ist somit nahezu identisch zu (Vᵢₙₚ - Vᵢₙₙ)/Rₑ. Dies entspricht dem Verhalten des in Fig. 5 dargestellten Verstärkers.

Der Strom, welcher aus dem Eingang 47 entnommen wird, ist die Summe der Basisströme der Transistoren Q1p und Q4p. Die Kollektorströme dieser Transistoren sind ½ Iₒᵤₜₙ und ½ Iₒᵤₜₚ. In sehr guter Näherung addieren sich die beiden Basisströme zu einer Konstante unabhängig von dem differentiellen Eingangssignal. Ebenso ist auch der Strom, welcher aus dem Eingang 48 entnommen wird, unabhängig von der Eingangsspannung. Die Nachbildungseinrichtung N1 kompensiert somit den Stromfluss in dem Eingangsanschluss 47 verursacht durch den ersten Strompfad I1, während die Nachbildungseinrichtung N2 den Stromfluss in dem Eingangsanschluss 48 verursacht durch den zweiten Strompfad I2 kompensiert.

Somit ist die Eingangsadmittanz der Schaltung nahezu Null. Mit detaillierten Berechnungen, welche finite Stromverstärkungen berücksichtigen, kann gezeigt werden, dass die Eingangsadmittanz bei Gleichspannung positiv ist und eine Größenordnung von 1/β² x Rₑ) auf weist. β ist dabei die Stromverstärkung der Transistoren. Die Eingangsadmittanz ist dabei bis zu sehr hohen Frequenzen sehr klein und positiv. Als Vergleich weist der Verstärker nach Fig. 3 eine Gleichspannungseingangsadmittanz von 1/(β x Rₑ) auf. Die Eingangsadmittanz der Verstärkerschaltung aus Fig. 5 entspricht ca. -1/(β x Rₑ).

Ein weiterer Vorteil der erfindungsgemäßen Verstärkerschaltung ist die Stabilität unabhängig von der Größe der Widerstände 43, 44. Es ist somit möglich eine sehr hohe Verstärkung in einem einstufigen differentiellen Verstärker zu erreichen. Das in Fig. 6 gezeigte Ausführungsbeispiel nutzt als Transistoren Bipolartransistoren. Ebenso können jedoch auch andere Transistorarten eingesetzt werden. So können z. B. MOS-Transistoren eingesetzt werden. Obwohl MOS-Transistoren bereits eine Admittanz von Null bei Gleichspannung haben, ist die erfindungsgemäße Verstärkerschaltung noch immer nützlich, da sie eine sehr geringe Eingangskapazität gegenüber herkömmlichen differentiellen Paaren oder gegenüber Caprio's Quad aufweist.

Die Erfindung ist nicht auf das dargestellte Ausführungsbeispiel beschränkt. Wie bereits erwähnt, können z.B. unterschiedliche Transistorarten eingesetzt werden. Alle vorstehend beschriebenen Merkmale oder in den Figuren gezeigten Merkmale sind im Rahmen der Erfindung beliebig vorteilhaft miteinander kombinierbar.

## Patentansprüche

1. Differentieller Verstärker mit einer Verstärkerschaltung bestehend aus zwei differentiellen Paaren (Q1, Q2),
wobei ein erstes differentielles Paar (Q1) in Serie zu einem zweiten differentiellen Paar (Q2) geschaltet ist, wobei das zweite differentielle Paar (Q2) an Steueranschlüssen überkreuz zumindest mittelbar mit einem differentiellen Ausgangssignal (Iₒᵤₜₚ, Iₒᵤₜₙ) des ersten differentiellen Paars (Q1) verbunden ist,
wobei das erste differentielle Paar (Q1) und das zweite differentielle Paar (Q2) einen ersten differentiellen Strompfad (I1) und einen zweiten differentiellen Strompfad (I2) bilden,,
wobei dem ersten Strompfad (I1) eine erste Nachbildungseinrichtung (N1) parallel geschaltet ist, und wobei dem zweiten Strompfad (I2) eine zweite Nachbildungseinrichtung (N2) parallel geschaltet ist,
**dadurch gekennzeichnet,**
**dass** die erste Nachbildungseinrichtung (N1) aus einer Serienschaltung eines ersten Transistors (Q4p) und eines zweiten Transistors (Q3p) besteht, und
**dass** die zweite Nachbildungseinrichtung (N2) aus einer Serienschaltung eines dritten Transistors (Q4n) und eines vierten Transistors (Q3n) besteht.

2. Differentieller Verstärker nach Anspruch 1,
**dadurch gekennzeichnet,**
**dass** die erste Nachbildungseinrichtung (N1) dazu ausgebildet ist, den Stromfluss durch den ersten Strompfad (I1) nachzubilden, und
**dass** die zweite Nachbildungseinrichtung (N2) dazu ausgebildet ist, den Stromfluss durch den zweiten Strompfad (N2) nachzubilden.

3. Differentieller Verstärker nach Anspruch 2,
**dadurch gekennzeichnet,**
**dass** der erste Strompfad (I1) an einem Steuereingang mit einem ersten Teilsignal (Vinn) eines differentiellen Eingangssignals beaufschlagt ist,
**dass** der zweite Strompfad (I2) an einem Steuereingang mit einem zweiten Teilsignal (Vᵢₙₚ) des differentiellen Eingangssignals beaufschlagt ist,
**dass** die erste Nachbildungseinrichtung (N1) an einem Steuereingang mit dem zweiten Teilsignal (Vinn) des differentiellen Eingangssignals beaufschlagt ist, und dass die zweite Nachbildungseinrichtung (N2) an einem Steuereingang mit dem ersten Teilsignal (Vᵢₙₚ) des differentiellen Eingangssignals beaufschlagt ist.

4. Differentieller Verstärker nach Anspruch 3,
**dadurch gekennzeichnet,**
**dass** die erste Nachbildungseinrichtung (N1) dazu ausgebildet ist, dass ein Stromfluss durch den Steuereingang der ersten Nachbildungseinrichtung (N1) einen Stromfluss durch den Steuereingang des ersten Strompfads (I1) kompensiert, und
**dass** die zweite Nachbildungseinrichtung (N2) dazu ausgebildet ist, dass ein Stromfluss durch den Steuereingang der zweiten Nachbildungseinrichtung (N2) einen Stromfluss durch den Steuereingang des zweiten Strompfads (I2) kompensiert.

5. Differentieller Verstärker nach einem der Ansprüche 1 bis 4,
**dadurch gekennzeichnet,**
**dass** das erste differentielle Paar (Q1) aus einem fünften Transistor (Q1n) und einem sechsten Transistor (Q1p) besteht,
**dass** das zweite differentielle Paar (Q2) aus einem siebten Transistor (Q2p) und einem achten Transistor (Q2n) besteht.

6. Differentieller Verstärker nach Anspruch 5,
**dadurch gekennzeichnet,**
**dass** erste Anschlüsse des fünften Transistors (Q1n) und des sechsten Transistors (Q1p) jeweils mit einem Ausgang (45, 46) verbunden sind,
**dass** ein zweiter Anschluss des fünften Transistors (Q1n) mit einem ersten Anschluss des siebten Transistors (Q2p) und ein zweiter Anschluss des sechsten Transistors (Q1p) mit einem ersten Anschluss des achten Transistors (Q2n) verbunden sind,
**dass** ein zweiter Anschluss des siebten Transistors (Q2p) über einen ersten Widerstand (43) und eine Stromquelle (42) mit Masse und ein zweiter Anschluss des achten Transistors (Q2n) über einen zweiten Widerstand und die Stromquelle (42) mit Masse verbunden sind,
**dass** dritte Anschlüsse des fünften Transistors (Q1n) und des sechsten Transistors (Q1p) jeweils mit einem Eingang (47, 48) verbunden sind, und
**dass** der zweite Anschluss des fünften Transistors (Q1n) mit einem dritten Anschluss des achten Transistors (Q2n) und der zweite Anschluss des sechsten Transistors (Q1p) mit einem dritten Anschluss des siebten Transistors (Q2p) verbunden sind.

7. Differentieller Verstärker nach Anspruch 5 oder 6,
**dadurch gekennzeichnet,**
**dass** erste Anschlüsse des ersten Transistors (Q4p) und des dritten Transistors (Q4n) mit Ausgängen (45, 46) verbunden sind, und
**dass** dritte Anschlüsse des ersten Transistors (Q4p) und des dritten Transistors (Q4n) jeweils mit einem Eingang (47, 48) verbunden sind.

8. Differentieller Verstärker nach Anspruch 6,
**dadurch gekennzeichnet,**
**dass** der erste Anschluss des fünften Transistors (Q1n) mit dem ersten Ausgang (45) verbunden ist,
**dass** der erste Anschluss des sechsten Transistors (Q1p) mit dem zweiten Ausgang (46) verbunden ist,
**dass** der dritte Anschluss des fünften Transistors (Q1n) mit dem zweiten Eingang (48) verbunden ist, und
**dass** der dritte Anschluss des sechsten Transistors (Q1p) mit dem ersten Eingang (47) verbunden ist.

9. Differentieller Verstärker nach Anspruch 6 oder 7,
**dadurch gekennzeichnet,**
**dass** der erste Anschluss des ersten Transistors (Q4p) mit dem ersten Ausgang (45) verbunden ist,
**dass** der erste Anschluss des dritten Transistors (Q4n) mit dem zweiten Ausgang (46) verbunden ist,
**dass** der dritte Anschluss des ersten Transistors (Q4p) mit dem ersten Eingang (47) verbunden ist,
**dass** der dritte Anschluss des dritten Transistors (Q4n) mit dem zweiten Eingang (47) verbunden ist,

10. Differentieller Verstärker nach einem der Ansprüche 6 bis 9,
**dadurch gekennzeichnet,**
**dass** ein zweiter Anschluss des ersten Transistors (Q4p) mit einem ersten Anschluss des zweiten Transistors (Q3p) und ein zweiter Anschluss des dritten Transistors (Q4n) mit einem ersten Anschluss des vierten Transistors (Q3n) verbunden sind,
**dass** ein zweiter Anschluss des zweiten Transistors (Q3p) mit dem zweiten Anschluss des siebten Transistors (Q2p) und ein zweiter Anschluss des vierten Transistors (Q3n) mit dem zweiten Anschluss des achten Transistors (Q2n) verbunden sind, und
**dass** ein dritter Anschluss des zweiten Transistors (Q3p) mit dem zweiten Anschluss des sechsten Transistors (Q1p) und ein dritter Anschluss des vierten Transistors (Q3n) mit dem zweiten Anschluss des fünften Transistors (Q1p) verbunden sind.

11. Differentieller Verstärker nach einem der Ansprüche 6 bis 10,
**dadurch gekennzeichnet,**
**dass** die ersten Anschlüsse der Transistoren Kollektor-Anschlüsse oder Drain-Anschlüsse sind,
**dass** die zweiten Anschlüsse der Transistoren EmitterAnschlüsse oder Source-Anschlüsse sind, und
**dass** die dritten Anschlüsse der Transistoren BasisAnschlüsse oder Gate-Anschlüsse sind.

12. Differentieller Verstärker nach einem der Ansprüche 1 bis 11,
**dadurch gekennzeichnet,**
**dass** der Verstärker dazu ausgebildet ist, um dem ersten Eingang (47) und dem zweiten Eingang (48) nur einen sehr geringen Strom, insbesondere keinen Strom zu entnehmen.

13. Differentieller Verstärker nach einem der Ansprüche 5 bis 12,
**dadurch gekennzeichnet,**
**dass** der fünfte Transistor (Q1n) baugleich zu dem ersten Transistor (Q4p) ist,
**dass** der sechste Transistor (Q1p) baugleich zu dem dritten Transistor (Q4n) ist,
**dass** der siebte Transistor (Q2p) baugleich zu dem zweiten Transistor (Q3p) ist, und
**dass** der achte Transistor (Q2n) baugleich zu dem vierte Transistor (Q3n) ist.

14. Differentieller Verstärker nach einem der Ansprüche 5 bis 13,
**dadurch gekennzeichnet,**
**dass** sämtliche Transistoren (Q1n, Q1p, Q2n, Q2p, Q3n, Q3p, Q4n, Q4p) baugleich sind.

15. Differentieller Verstärker nach einem der Ansprüche 5 bis 14,
**dadurch gekennzeichnet,**
**dass** ein Strom (1/2 Iₒᵤₜₚ) durch den fünften Transistor (Q1n) und siebte Transistor (Q2p) einem Strom (1/2 Iₒᵤₜₚ) durch den ersten Transistor (Q4p) weitgehend entspricht, und
**dass** ein Strom (1/2 Iₒᵤₜₙ) durch den sechsten Transistor (Q1p) und achsten Transistor (Q2n) einem Strom (1/2 Iₒᵤₜₙ) durch den dritten Transistor (Q4n) weitgehend entspricht.

16. Differentieller Verstärker nach einem der Ansprüche 5 bis 15,
**dadurch gekennzeichnet,**
**dass** ein Strom (1/2 Iₒᵤₜₚ) durch den fünften Transistor (Q1n) und siebten Transistor (Q2p) einem Strom (1/2 Iₒᵤₜₚ) durch den ersten Transistor (Q4p) und zweiten Transistor (Q3p) weitgehend entspricht, und
**dass** ein Strom (1/2 Iₒᵤₜₙ) durch den sechsten Transistor (Q1p) und achten Transistor (Q2n) einem Strom (1/2 Iₒᵤₜₙ) durch den dritten Transistor (Q4n) und vierten Transistor (Q3n) weitgehend entspricht.

17. Differentieller Verstärker nach einem der Ansprüche 5 bis 16,
**dadurch gekennzeichnet,**
**dass** die Transistoren (Q1n, Q1p, Q2n, Q2p, Q3n, Q3p, Q4n, Q4p) Bipolartransistoren und/oder Feldeffekttransistoren sind.

## Claims

1. Differential amplifier with an amplifier circuit comprising two differential pairs (Q1, Q2), wherein a first differential pair (Q1) is connected in series to a second differential pair (Q2), wherein the second differential pair (Q2) is connected at control terminals in a crosswise manner at least indirectly to a differential output signal (Iₒᵤₜₚ, Iₒᵤₜₙ) of the first differential pair (Q1),
wherein the first differential pair (Q1) and the second differential pair (Q2) form a first differential current path (I1) and a second differential current path (I2),
wherein a first emulation device (N1) is connected in parallel to the first current path (I1), and wherein a second emulation device (N2) is connected in parallel to the second current path (I2), **characterised in that**
the first emulation device (N1) comprises a series connection of a first transistor (Q4p) and a second transistor (Q3p), and
**in that** the second emulation device (N2) comprises a series connection of a third transistor (Q4n) and a fourth transistor (Q3n).

2. Differential amplifier according to claim 1, **characterised in that**
the first emulation device (N1) is configured to emulate the current flow through the first current path (I1), and
**in that** the second emulation device (N2) is configured to emulate the current flow through the second current path (N2).

3. Differential amplifier according to claim 2, **characterised in that**
the first current path (I1) is supplied at a control input with a first partial signal (Vᵢₙₙ) of a differential input signal,
**in that** the second current path (I2) is supplied at a control input with a second partial signal (Vᵢₙₚ) of the differential input signal,
**in that** the first emulation device (N1) is supplied at a control input with the second partial signal (Vᵢₙₙ) of the differential input signal, and **in that** the second emulation device (N2) is supplied at a control input with the first partial signal (Vᵢₙₚ) of the differential input signal.

4. Differential amplifier according to claim 3, **characterised in that**
the first emulation device (N1) is configured so that a current flow through the control input of the first emulation device (N1) compensates a current flow through the control input of the first current path (I1), and
**in that** the second emulation device (N2) is configured so that a current flow through the control input of the second emulation device (N2) compensates a current flow through the control input of the second current path (I2).

5. Differential amplifier according to any one of claims 1 to 4,
**characterised in that**
the first differential pair (Q1) comprises a fifth transistor (Q1n) and a sixth transistor (Q1p), and **in that** the second differential pair (Q2) comprises a seventh transistor (Q2p) and an eighth transistor (Q2n).

6. Differential amplifier according to claim 5,
**characterised in that**
first terminals of the fifth transistor (Q1n) and of the sixth transistor (Q1p) are each connected to an output (45, 46),
**in that** a second terminal of the fifth transistor (Q1n) is connected to a first terminal of the seventh transistor (Q2p), and a second terminal of the sixth transistor (Q1p) is connected to a first terminal of the eighth transistor (Q2n),
**in that** a second terminal of the seventh transistor (Q2p) is connected via a first resistor (43) and a current source (42) to earth, and a second terminal of the eighth transistor (Q2n) is connected via a second resistor and the current source (42) to earth,
**in that** third terminals of the fifth transistor (Q1n) and of the sixth transistor (Q1p) are each connected to an input (47, 48), and
**in that** the second terminal of the fifth transistor (Q1n) is connected to a third terminal of the eighth transistor (Q2n), and the second terminal of the sixth transistor (Q1p) is connected to a third terminal of the seventh transistor (Q2p).

7. Differential amplifier according to claim 5 or 6,
**characterised in that**
first terminals of the first transistor (Q4p) and of the third transistor (Q4n) are connected to outputs (45, 46), and
**in that** third terminals of the first transistor (Q4p) and of the third transistor (Q4n) are each connected to an input (47, 48).

8. Differential amplifier according to claim 6,
**characterised in that**
the first terminal of the fifth transistor (Q1n) is connected to the first output (45),
**in that** the first terminal of the sixth transistor (Q1p) is connected to the second output (46),
**in that** the third terminal of the fifth transistor (Q1n) is connected to the second input (48), and **in that** the third terminal of the sixth transistor (Q1p) is connected to the first input (47).

9. Differential amplifier according to claim 6 or 7,
**characterised in that**
the first terminal of the first transistor (Q4p) is connected to the first output (45),
**in that** the first terminal of the third transistor (Q4n) is connected to the second output (46),
**in that** the third terminal of the first transistor (Q4p) is connected to the first input (47), and **in that** the third terminal of the third transistor (Q4n) is connected to the second input (47).

10. Differential amplifier according to any one of claims 6 to 9,
**characterised in that**
a second terminal of the first transistor (Q4p) is connected to a first terminal of the second transistor (Q3p), and a second terminal of the third transistor (Q4n) is connected to a first terminal of the fourth transistor (Q3n),
**in that** a second terminal of the second transistor (Q3p) is connected to the second terminal of the seventh transistor (Q2p), and a second terminal of the fourth transistor (Q3n) is connected to the second terminal of the eighth transistor (Q2n), and **in that** a third terminal of the second transistor (Q3p) is connected to the second terminal of the sixth transistor (Q1p), and a third terminal of the fourth transistor (Q3n) is connected to the second terminal of the fifth transistor (Q1p).

11. Differential amplifier according to any one of claims 6 to 10,
**characterised in that**
the first terminals of the transistors are collector terminals or drain terminals,
**in that** the second terminals of the transistors are emitter terminals or source terminals, and
**in that** the third terminals of the transistors are base terminals or gate terminals.

12. Differential amplifier according to any one of claims 1 to 11,
**characterised in that**
the amplifier is configured to draw only a very small current, in particular no current, from the first input (47) and the second input (48).

13. Differential amplifier according to any one of claims 5 to 12,
**characterised in that**
the fifth transistor (Q1n) is of identical structure to the first transistor (Q4p),
**in that** the sixth transistor (Q1p) is of identical structure to the third transistor (Q4n),
**in that** the seventh transistor (Q2p) is of identical structure to the second transistor (Q3p), and
**in that** the eighth transistor (Q2n) is of identical structure to the fourth transistor (Q3n).

14. Differential amplifier according to any one of claims 5 to 13,
**characterised in that**
all of the transistors (Q1n, Q1p, Q2n, Q2p, Q3n, Q3p, Q4n, Q4p) are of identical structure.

15. Differential amplifier according to any one of claims 5 to 14,
**characterised in that**
a current (1/2 Iₒᵤₜₚ) through the fifth transistor (Q1n) and seventh transistor (Q2p) largely corresponds to a current (1/2 Iₒᵤₜₚ) through the first transistor (Q4p), and
**in that** a current (1/2 Iₒᵤₜₙ) through the sixth transistor (Q1p) and eighth transistor (Q2n) largely corresponds to a current (1/2 Iₒᵤₜₙ) through the third transistor (Q4n).

16. Differential amplifier according to any one of claims 5 to 15,
**characterised in that**
a current (1/2 Iₒᵤₜₚ) through the fifth transistor (Q1n) and seventh transistor (Q2p) largely corresponds to a current (1/2 Iₒᵤₜₚ) through the first transistor (Q4p) and second transistor (Q3p), and
**in that** a current (1/2 Iₒᵤₜₙ) through the sixth transistor (Q1p) and eighth transistor (Q2n) largely corresponds to a current (1/2 Iₒᵤₜₙ) through the third transistor (Q4n) and fourth transistor (Q3n).

17. Differential amplifier according to any one of claims 5 to 16,
**characterised in that**
the transistors (Q1n, Q1p, Q2n, Q2p, Q3n, Q3p, Q4n, Q4p) are bipolar transistors and/or field-effect transistors.

## Revendications

1. Amplificateur différentiel comprenant un circuit amplificateur constitué de deux paires différentielles (Q1, Q2),
dans lequel une première paire différentielle (Q1) est montée en série avec une deuxième paire différentielle (Q2),
dans lequel la deuxième paire différentielle (Q2) est au moins indirectement reliée en croix par des connexions de commande à un signal de sortie différentiel (Iₒᵤₜₚ, Iₒᵤₜₙ) de la première paire différentielle (Q1),
dans lequel la première paire différentielle (Q1) et la deuxième paire différentielle (Q2) forment un premier trajet de courant différentiel (I1) et un deuxième trajet de courant différentiel (I2),
dans lequel un premier dispositif de reproduction (N1) est monté en parallèle avec le premier trajet de courant (I1), et
dans lequel un deuxième dispositif de reproduction (N2) est monté en parallèle avec le deuxième trajet de courant (I2),
**caractérisé**
**en ce que** le premier dispositif de reproduction (N1) est constitué d'un montage en série d'un premier transistor (Q4p) et d'un deuxième transistor (Q3p), et
**en ce que** le deuxième dispositif de reproduction (N2) est constitué d'un montage en série d'un troisième transistor (Q4n) et d'un quatrième transistor (Q3n).

2. Amplificateur différentiel selon la revendication 1,
**caractérisé**
**en ce que** le premier dispositif de reproduction (N1) est prévu pour reproduire le flux de courant sur le premier trajet de courant (I1), et
**en ce que** le deuxième dispositif de reproduction (N2) est prévu pour reproduire le flux de courant sur le deuxième trajet de courant (N2).

3. Amplificateur différentiel selon la revendication 2,
**caractérisé**
**en ce qu'**un premier signal partiel (Vᵢₙₙ) d'un signal d'entrée différentiel est appliqué sur le premier trajet de courant (I1) à une entrée de commande,
**en ce qu'**un deuxième signal partiel (Vᵢₙₚ) du signal d'entrée différentiel est appliqué sur le deuxième trajet de courant (12) à une entrée de commande,
**en ce que** le deuxième signal partiel (Vᵢₙₙ) du signal d'entrée différentiel est appliqué sur le premier dispositif de reproduction (N1) à une entrée de commande, et
**en ce que** le premier signal partiel (Vᵢₙₚ) du signal d'entrée différentiel est appliqué sur le deuxième dispositif de reproduction (N2) à une entrée de commande.

4. Amplificateur différentiel selon la revendication 3,
**caractérisé**
**en ce que** le premier dispositif de reproduction (N1) est prévu de telle manière qu'un flux de courant par l'entrée de commande du premier dispositif de reproduction (N1) compense un flux de courant par l'entrée de commande du premier trajet de courant (I1), et
**en ce que** le deuxième dispositif de reproduction (N2) est prévu de telle manière qu'un flux de courant par l'entrée de commande du deuxième dispositif de reproduction (N2) compense un flux de courant par l'entrée de commande du deuxième trajet de courant (I2).

5. Amplificateur différentiel selon l'une des revendications 1 à 4,
**caractérisé**
**en ce que** la première paire différentielle (Q1) est constituée d'un cinquième transistor (Q1n) et d'un sixième transistor (Q1p),
**en ce que** la deuxième paire différentielle (Q2) est constituée d'un septième transistor (Q2p) et d'un huitième transistor (Q2n).

6. Amplificateur différentiel selon la revendication 5,
**caractérisé**
**en ce que** des premières connexions du cinquième transistor (Q1n) et du sixième transistor (Q1p) sont reliées chacune à une sortie (45, 46),
**en ce qu'**une deuxième connexion du cinquième transistor (Q1n) est reliée à une première connexion du septième transistor (Q2p) et une deuxième connexion du sixième transistor (Q1p) est reliée à une première connexion du huitième transistor (Q2n),
**en ce qu'**une deuxième connexion du septième transistor (Q2p) est reliée à la masse par une première résistance (43) et une source de courant (42) et une deuxième connexion du huitième transistor (Q2n) est reliée à la masse par une deuxième résistance et la source de courant (42),
**en ce que** des troisièmes connexions du cinquième transistor (Q1n) et du sixième transistor (Q1p) sont reliées chacune à une entrée (47, 48), et
**en ce que** la deuxième connexion du cinquième transistor (Q1n) est reliée à une troisième connexion du huitième transistor (Q2n) et la deuxième connexion du sixième transistor (Q1p) est reliée à une troisième connexion du septième transistor (Q2p).

7. Amplificateur différentiel selon la revendication 5 ou 6,
**caractérisé**
**en ce que** des premières connexions du premier transistor (Q4p) et du troisième transistor (Q4n) sont reliées à des sorties (45, 46), et
**en ce que** des troisièmes connexions du premier transistor (Q4p) et du troisième transistor (Q4n) sont reliées chacune à une entrée (47, 48) .

8. Amplificateur différentiel selon la revendication 6,
**caractérisé**
**en ce que** la première connexion du cinquième transistor (Q1n) est reliée à la première sortie (45),
**en ce que** la première connexion du sixième transistor (Q1p) est reliée à la deuxième sortie (46),
**en ce que** la troisième connexion du cinquième transistor (Q1n) est reliée à la deuxième entrée (48), et
**en ce que** la troisième connexion du sixième transistor (Q1p) est reliée à la première entrée (47).

9. Amplificateur différentiel selon la revendication 6 ou 7,
**caractérisé**
**en ce que** la première connexion du premier transistor (Q4p) est reliée à la première sortie (45),
**en ce que** la première connexion du troisième transistor (Q4n) est reliée à la deuxième sortie (46),
**en ce que** la troisième connexion du premier transistor (Q4p) est reliée à la première entrée (47),
**en ce que** la troisième connexion du troisième transistor (Q4n) est reliée à la deuxième entrée (47),

10. Amplificateur différentiel selon l'une des revendications 6 à 9,
**caractérisé**
**en ce qu'**une deuxième connexion du premier transistor (Q4p) est reliée à une première connexion du deuxième transistor (Q3p) et une deuxième connexion du troisième transistor (Q4n) est reliée à une première connexion du quatrième transistor (Q3n),
**en ce qu'**une deuxième connexion du deuxième transistor (Q3p) est reliée à la deuxième connexion du septième transistor (Q2p) et une deuxième connexion du quatrième transistor (Q3n) est reliée à la deuxième connexion du huitième transistor (Q2n), et
**en ce qu'**une troisième connexion du deuxième transistor (Q3p) est reliée à la deuxième connexion du sixième transistor (Q1p) et une troisième connexion du quatrième transistor (Q3n) est reliée à la deuxième connexion du cinquième transistor (Q1p).

11. Amplificateur différentiel selon l'une des revendications 6 à 10,
**caractérisé**
**en ce que** les premières connexions des transistors sont des bornes de collecteur ou des bornes de drain,
**en ce que** les deuxièmes connexions des transistors sont des bornes d'émetteur ou des bornes de source, et
**en ce que** les troisièmes connexions des transistors sont des bornes de base ou des bornes de grille.

12. Amplificateur différentiel selon l'une des revendications 1 à 11,
**caractérisé**
**en ce que** ledit amplificateur est prévu pour ne prélever qu'un très faible courant, en particulier aucun courant, à la première entrée (47) et à la deuxième entrée (48).

13. Amplificateur différentiel selon l'une des revendications 5 à 12,
**caractérisé**
**en ce que** le cinquième transistor (Q1n) est identique au premier transistor (Q4p),
**en ce que** le sixième transistor (Q1p) est identique au troisième transistor (Q4n),
**en ce que** le septième transistor (Q2p) est identique au deuxième transistor (Q3p), et
**en ce que** le huitième transistor (Q2n) est identique au quatrième transistor (Q3n).

14. Amplificateur différentiel selon l'une des revendications 5 à 13,
**caractérisé**
**en ce que** tous les transistors (Q1n, Q1p, Q2n, Q2p, Q3n, Q3p, Q4n, Q4p) sont identiques.

15. Amplificateur différentiel selon l'une des revendications 5 à 14,
**caractérisé**
**en ce qu'**un courant (1/2 Iₒᵤₜₚ) par le cinquième transistor (Q1n) et le septième transistor (Q2p) correspond sensiblement à un courant (1/2 Iₒᵤₜₚ) par le premier transistor (Q4p), et
**en ce qu'**un courant (1/2 Iₒᵤₜₙ) par le sixième transistor (Q1p) et le huitième transistor (Q2n) correspond sensiblement à un courant (1/2 Iₒᵤₜₙ) par le troisième transistor (Q4n).

16. Amplificateur différentiel selon l'une des revendications 5 à 15,
**caractérisé**
**en ce qu'**un courant (1/2 Iₒᵤₜₚ) par le cinquième transistor (Q1n) et le septième transistor (Q2p) correspond sensiblement à un courant (1/2 Iₒᵤₜₚ) par le premier transistor (Q4p) et le deuxième transistor (Q3p), et
**en ce qu'**un courant (1/2 Iₒᵤₜₙ) par le sixième transistor (Q1p) et le huitième transistor (Q2n) correspond sensiblement à un courant (1/2 Iₒᵤₜₙ) par le troisième transistor (Q4n) et le quatrième transistor (Q3n).

17. Amplificateur différentiel selon l'une des revendications 5 à 16,
**caractérisé**
**en ce que** les transistors (Q1n, Q1p, Q2n, Q2p, Q3n, Q3p, Q4n, Q4p) sont des transistors bipolaires et/ou des transistors à effet de champ.
